# EUROPÄISCHE PATENTSCHRIFT

(11) **EP 0 799 849 B1**
(45) Veröffentlichungstag und Bekanntmachung des Hinweises auf die Patenterteilung: **20.08.2003**
(21) Anmeldenummer: 97103929.2
(22) Anmeldetag: 10.03.1997
(51) Int. Cl.: C08G 59/30, C08G 59/14

(54) **Verfahren zur Herstellung phosphormodifizierter Epoxidharze**
Process for the preparation of phosphorus modified epoxy resins
Procédé pour la préparation de résines époxydes modifiées par du phospore

(30) Priorität: 01.04.1996 DE 19613066
(43) Veröffentlichungstag der Anmeldung: 08.10.1997
(73) Patentinhaber: Clariant GmbH, 65929 Frankfurt am Main (DE)
(72) Erfinder: Hörold, Sebastian Dr., 50374 Erftstadt (DE); Schmitz, Hans-Peter, 50321 Brühl (DE)

(56) Entgegenhaltungen:
- EP-A- 0 412 425
- DE-A- 2 920 718
- GB-A- 1 031 369
- JP-A- 6 080 765
- US-A- 3 236 863
- US-A- 5 294 265
- DATABASE WPI Derwent Publications Ltd., London, GB; AN 80-42858c XP002032110 & SU 688 504 A (KAZAN SYNTH RUBBER) , 12.November 1979

## Beschreibung

Die vorliegende Erfindung betrifft ein Verfahren zur Herstellung phosphormodifizierter Epoxidharze.

Epoxidharze werden heute zur Herstellung von Formmassen und Beschichtungen mit hohen thermischen, mechanischen und elektronischen Eigenschaften eingesetzt. Sie sind geeignet zum Verguß von elektrischen bzw. elektronischen Bauteilen und für Tränk- und Imprägnierprozesse. In der Elektrotechnik werden die verwendeten Epoxidharz-Formmassen überwiegend flammwidrig ausgerüstet.

Epoxidharz-Formmassen werden im allgemeinen mit bromhaltigen aromatischen Verbindungen, insbesondere Tetrabrombisphenol A, flammwidrig ausgerüstet. Werden ausschließlich bromierte Flammschutzmittel eingesetzt, so wird ein Bromgehalt von etwa 20 % benötigt, um ein Selbstverlöschen der Formmassen zu gewährleisten. Als Synergist wird häufig Antimontrioxid verwendet. Im Brandfall wird Bromwasserstoff freigesetzt, was zu Schäden durch Korrrosion führen kann. Unter ungünstigen Bedingungen können auch polybromierte Dibenzodioxine und Furane entstehen. Es besteht von daher ein Bedarf an Epoxidharz-Formmassen, die die geforderte Flammwidrigkeit ohne Zusatz bromierter Verbindungen erreichen.

Zur flammwidrigen Ausrüstung von Epoxidharz-Formmassen wurden Füllstoffe mit Löschwirkung wie Aluminiumoxidhydrat (DE 35 40 524 A1) vorgeschlagen. Auch durch den Zusatz von Ammoniumpolyphosphat, gegebenenfalls in Kombination mit Aluminiumoxidhydrat, kann eine hinreichende Flammwidrigkeit erreicht werden. Anstelle von Ammoniumpolyphosphat kann auch roter Phosphor verwendet werden (DE 17 45 796 A1).

Nachteilig bei allen als Füllstoff vorliegenden Flammschutzmitteln ist, daß keine Transparenz der Materialien erhalten wird. Es wurden bereits zahlreiche flüssige phosphororganische Verbindungen als flammhemmende Kunststoffzusätze vorgeschlagen. Nachteilig bei diesen Systemen ist aber der ausgeprägte "Weichmachereffekt" dieser Zusätze. Bei gehärteten Epoxidharzen äußert sich der weichmachende Effekt in einer starken Herabsetzung der Glasübergangstemperatur.

Die flammwidrige Ausstattung von Epoxidharzen mit epoxidfunktionellen Phosphonsäureestern ist bereits beschrieben (EP 0 384 939 A1). Nachteilig bei diesen Systemen ist der hohe Syntheseaufwand derartiger Phosphonsäureester. In der Literatur bekannt sind auch phosphormodifizierte Epoxidharze, die durch Umsetzung von Polyepoxidverbindungen mit Anhydriden von Phosphonsäuren oder Phosphinsäuren zugänglich sind und sich durch gute flammwidrige Eigenschaften auszeichnen (DE 43 08 185 A1). Technisch leichter zugänglich als die Anhydride sind carboxyfunktionelle Phosphon- und Phosphinsäuren. Derartige Produkte werden bereits zur flammwidrigen Ausrüstung von Polyesterfasern verwendet (US 5,399,428 A1).

Aufgabe der Erfindung war es, ein Verfahren zur Herstellung von phosphormodifizierten Epoxidharzen zur Verfügung zu stellen, mit dem sich die gewünschten Produkte einfach und kostengünstig herstellen lassen.

Gelöst wird diese Aufgabe durch ein Verfahren der eingangs beschriebenen Art, dadurch gekennzeichnet, daß man eine Polyepoxidverbindung mit mindestens 2 Epoxidgruppen pro Molekühl mit carboxylhaltigen Phosphin säuren der allgemeinen Formel I 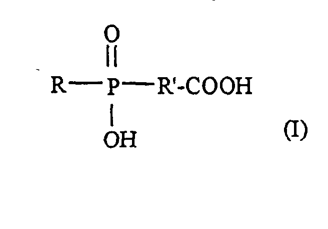 umsetzt,
wobei R geradlinige oder verzweigte Alkyl-, Cycloalkyl-, Aryl- oder Alkylarylgruppen mit 1 bis 18, vorzugsweise 1 bis 6 C-Atomen bedeutet oder Wasserstoff und R' geradlinige oder verzweigte Alkylen-, Cycloalkylen-, Arylen- oder Alkylarylengruppen mit 1 bis 18, vorzugsweise 1 bis 6 C-Atomen und besonders bevorzugt 1-2 C-Atomen bedeutet.

Bevorzugt handelt es sich bei den Phosphinsäuren um 2-Carboxyethan-methan-phosphinsäure, 2-Carboxyethan-phenyl-phosphinsäure oder 2-Carboxymethyl-methan-phosphinsäure.

Bevorzugt erfolgt die Umsetzung in einem Lösungsmittel.

Bevorzugt werden aprotische, polare Lösungsmittel, wie N-methylpyrrolidon, Dimethylformamid, Tetrahydrofuran, Dioxan, Dialkylether, Glykolether, Ketone und/oder Ester eingesetzt.

Ebenfalls bevorzugt werden als Lösungsmittel halogenierte Kohlenwasserstoffe, aliphatische, cycloaliphatische und/oder aromatische Kohlenwasserstoffe, einzeln oder als Gemische, eingesetzt.

Bevorzugt erfolgt die Umsetzung bei Temperaturen von 20 bis 150 °C.

Bevorzugt beträgt das Äquivalentverhältnis zwischen Polyepoxidverbindung und carboxylgruppenhaltiger Phosphin säure 1 : 0,1 bis 1 : 0,8.

Die nach den erfindungsgemäßen Verfahren erhaltenen phosphormodifizierten Epoxidharze eignen sich zur Herstellung von Formkörpern, Beschichtungen oder Laminaten.

Die Erfindung betrifft ebenfalls Formkörper, Beschichtungen oder Laminate, hergestellt unter Verwendung des phosphormodifizierten Epoxidharzes erhalten nach dem erfindungsgemäßen Verfahren.

Die der Erfindung zugrundeliegenden carboxyfunktionellen Phosphinsäuren können beispielsweise durch Addition geeigneter Phosphorverbindungen an Acrylsäure oder Acrylsäureester hergestellt werden.

Die Phosphorverbindung kann vorzugsweise Methanphosphonigsäuredichlorid sein. Addition an Acrylsäure und anschließende Hydrolyse liefert Carboxyethyl-methyl-phosphinsäure (III) (DE 25 40 283 A1). Analog kann auch Phenylphosphonigsäuredichlorid verwendet werden.

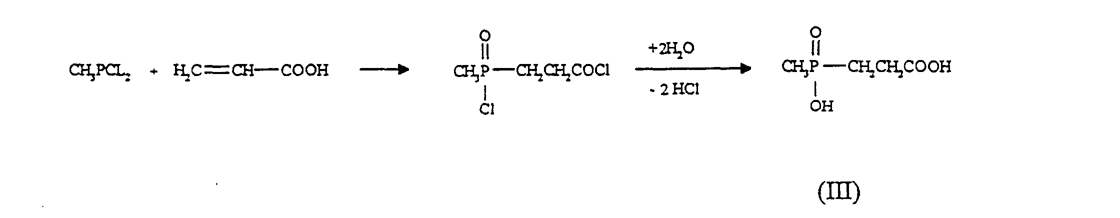

Die erfindungsgemäß eingesetzten halogenfreien Epoxidverbindungen (im folgenden auch Polyepoxidverbindungen genannt) können gesättigt oder ungesättigt sowie aliphatisch, cycloaliphatisch, aromatisch und/oder heterocyclisch sein. Sie können weiterhin solche Substituenten enthalten, die unter den Mischungs- oder Reaktionsbedingungen keine störenden Nebenreaktionen verursachen, beispielsweise Alkyl- oder Arylsubstituenten, Ethergruppierungen oder ähnliche. Es können auch Gemische verschiedener Polyepoxidverbindungen verwendet werden. Das mittlere Molekulargewicht Mₙ dieser Polyepoxidverbindungen kann bis zu etwa 9000 betragen, liegt jedoch im allgemeinen bei etwa 150 bis 4000.

Beispielsweise handelt es sich bei diesen Polyepoxidverbindungen um Polyglycidylether auf Basis von mehrwertigen, vorzugsweise zweiwertigen Alkoholen, Phenolen, Hydrierungsprodukten dieser Phenole und/oder von Novolaken (Umsetzungsprodukte von ein- oder mehrwertigen Phenolen, wie Phenol und/oder Kresole, mit Aldehyden, insbesondere Formaldehyd in Gegenwart saurer Katalysatoren), die man in bekannter Weise, beispielsweise durch Umsetzung der jeweiligen Polyole mit Epichlorhydrin, erhält.

Als mehrwertige Phenole sind hier beispielsweise zu nennen: Resorcin, Hydrochinon, 2,2-Bis(4-hydroxyphenyl)propan (Bisphenol A), Isomerengemische des Dihydroxydiphenylmethans (Bisphenol F), 4,4'-Dihydroxydiphenylcyclohexan, 4,4'-Dihydroxy-3,3'-dimethyldiphenylpropan, 4,4'-Dihydroxydiphenyl, 4,4'-Dihydroxybenzophenon, Bis(4-hydroxyphenyl)1,1-ethan, Bis(4-hydroxyphenyl)1,1'-isobutan, Bis(4-hydroxy-tert.-butylphenyl)2,2-propan, Bis(2-hydroxynaphthyl)methan, 1,5-Dihydroxynaphthalin, Tris(4-hydroxyphenyl)methan, Bis(4-hydroxyphenyl)1, 1'-ether. Bisphenol A und Bisphenol F sind hierbei bevorzugt.

Auch die Polyglycidylether von mehrwertigen aliphatischen Alkoholen sind als Polyepoxidverbindung geeignet. Als Beispiele derartiger mehrwertiger Alkohole seien 1,4-Butandiol, 1,6-Hexandiol, Polyalkylenglykole, Glycerin, Trimethylolpropan, Bis(4-hydroxycyclohexyl)2,2-propan und Pentaerythrit genannt.

Weiter kommen als Polyepoxidverbindungen auch (Poly)glycidester in Frage, die man erhält durch Umsetzung von Epichlorhydrin oder ähnlichen Epoxyverbindungen mit einer aliphatischen, cycloaliphatischen oder aromatischen Polycarbonsäure, wie Oxalsäure, Adipinsäure, Glutarsäure, Phthal-, Isophthal-, Terephthal-, Tetrahydrophthal- oder Hexahydrophthalsäure, 2,6-Naphthalindicarbonsäure und dimerisierte Fettsäuren. Beispiele hierfür sind Terephthalsäurediglycidylester und Hexahydrophthalsäurediglycidylester.

Auch Polyepoxidverbindungen, die die Epoxidgruppen in statistischer Verteilung über die Molekülkette enthalten und die durch Emulsions-Copolymerisation unter Verwendung von olefinisch ungesättigten, diese Epoxidgruppen enthaltenden Verbindungen hergestellt werden können, wie z.B. Glycidylester der Acryl- oder Methacrylsäure, können in manchen Fällen vorteilhaft eingesetzt werden.

Weitere verwendbare Polyepoxidverbindungen sind beispielsweise solche auf der Basis heterocyclischer Ringsysteme, wie z.B. Hydantoinepoxidharze, Triglycidylisocyanurat und/oder dessen Oligomeren, Triglycidyl-p-aminophenol, Triglycidyl-p-aminodiphenylether, Tetraglycidyldiaminodiphenylmethan, Tetraglycidyldiaminodiphenylether, Tetrakis(4-glycidoxyphenyl)ethan, Urazolepoxide, Uracilepoxide, oxazolidinonmodifizierte Epoxidharze. Weiterhin Polyepoxide auf der Basis von aromatischen Aminen, wie Anilin, beispielsweise N,N-Diglycidylanilin, Diaminodiphenylmethan und N,N'-Dimethylaminodiphenylmethan oder -sulfon. Weitere geeignete Polyepoxidverbindungen sind im "Handbook of Epoxy Resins" von Henry Lee und Kris Neville, McGraw-Hill Book Company, 1967, in der Monographie von Henry Lee "Epoxy Resins", American Chemical Society, 1970, in Wagner/Sarx, "Lackkunstharze", Carl Hanser Verlag (1971), 5. Auflage, 174 ff., in der "Angew. Makromol. Chemie", Bd. 44 (1975), Seiten 151 bis 163, in der DE 27 57 733 A1 sowie in der EP 0 384 939 A1 beschrieben, auf die hiermit Bezug genommen wird.

Bevorzugt eingesetzte Polyepoxidverbindungen sind Bisglycidylether auf Basis von Bisphenol A, Bisphenol F und Bisphenol S (Umsetzungsprodukte dieser Bisphenole und Epichlor(halogen)hydrin) oder deren Oligomere, Polyglycidylether von Phenol/Formaldehyd- und/oder Kresol/Formaldehyd-Novolake sowie Diglycidylester der Phthal-, Isophthal-, Terephthal-, Tetrahydrophthal- und/oder Hexahydrophthalsäure sowie der Trimellithsäure, N-Glycidylverbindungen von aromatischen Aminen und heterocyclischen Stickstoffbasen, wie N,N-Diglycidylanilin, N,N,O-Triglycidyl-p-aminophenol, Triglycidylisocyanurat und N,N,N',N'-Tetraglycidylbis(p-aminophenyl)methan, Hydtantoin-Epoxidharze und Aracid-Epoxidharze sowie Di- und Polyglycidylverbindungen von mehrwertigen aliphatischen Alkoholen, wie 1,4-Butandiol, Trimethylolpropan und Polyalkylenglykolen.

Des weiteren sind auch oxazolidinonmodifizierte Epoxidharze geeignet. Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Die Polyepoxidharze können bei der Herstellung der erfindungsgemäßen Überzugsmasse einzeln oder im Gemisch vorliegen.

Der Ausdruck "Härten", wie er hier gebraucht wird, bedeutet die Umwandlung der löslichen, schmelzbaren Polyepoxide in feste, unlösliche und unschmelzbare, dreidimensional vernetzte Produkte, in der Regel unter gleichzeitiger Formgebung, etwa zu Imprägnierungen, Beschichtungen und Verklebungen.

Als Härter können bespielsweise aliphatische, cycloaliphatische, aromatische und heterocyclische Amine, wie Bis(4-aminophenyl)methan, Anilin-Formaldehyd-Harze, Bis(4-aminophenyl)sulfon, Ethylendiamin, Propan-1,3-diamin, Hexamethylendiamin, Diethylentriamin, Triethylentetramin, 2,2,4-Trimethylhexan-1,6-diamin, m-Xylylendiamin, Bis(4-aminocyclohexyl)methan, 2,2-Bis(4-aminocyclohexyl)propan, 3-Aminomethyl-3,5,5-trimethylcyclohexylamin (Isophorondiamin), Polyamidoamine, Polyphenole, wie Hydrochinon, Resorcin, 2,2-Bis(4-hydroxyphenyl)propan (Bisphenol A) und Phenol-Aldehyd-Harze, Polycarbonsäuren und deren Anhydride, wie zum Beispiel Phtalsäureanhydrid, Tetrahydrophtalsäureanhydrid, Hexahydrophtalsäureanhydrid, Pyromellithsäuredianhydrid eingesetzt werden. Darüber hinaus können auch katalytisch wirkende Härtungsmittel wie Cyanguanidine oder Friedel-Crafts-Katalysatoren wie Bortrifluorid verwendet werden.

Werden Amine als Härtungsmittel verwendet, so werden diese normalerweise in 0,75 bis 1,25 Äquivalenten pro Epoxidäquivalent eingesetzt. Bei Polycarbonsäuren der deren Anhydriden werden 0,4 bis 1,1 Äquivalente pro Epoxidäquivalent verwendet.

Als Beschleuniger kommen vor allem Imidazolderivate, beispielsweise 2-Methylimidazol, 2-Phenylimidazol und 2-Heptadecylimidazol in Frage; weiterhin Phosphine, Metallseifen und Acetylacetonate.

Als Reaktiv-Verdünner kommen beispielsweise mono- oder polyfunktionelle, niedermolekulare Alkohole, die mit Epichlorhydrin umgesetzt werden, in Frage.

Durch Variation des Äquivalentverhältnisses von Polyepoxidverbindung zu carboxyfunktioneller Phosphinsäure läßt sich der Phosphorgehalt des erfindungsgemäßen Harzes einstellen. Bevorzugt liegt das Äquivalentverhältnis zwischen 1 : 0,1 und 1 : 0,8 und besonders bevorzugt zwischen 1 : 0,1 und 1 : 0,4.

Falls Lösemittel eingesetzt werden, so sind diese aprotisch und vorzugsweise polar. Beispiele hierfür sind:

N-methylpyrrolidon, Dimethylformamid, Ether wie etwa Diethylether, Tetrahydrofuran, Dioxan, Ethylglykolether, Propylenglykolether, Butylglykolether von Monoalkoholen mit einem ggf. verzweigten Alkylrest von 1 bis 6 Kohlenstoffatomen.

Andere Lösungsmittel sind z.B. Ketone, wie etwa Aceton, Methylethylketon, Methylisopropylketon, Methylisobutylketon, Cyclohexanon und ähnliche, aber auch Ester, wie Ethylacetat, Butylacetat, Ethylenglycolacetat und Methoxypropylacetat können eingesetzt werden.

Weitere geeignete Lösungsmittel sind halogenierte Kohlenwasserstoffe sowie cycloaliphatische und/oder aromatische Kohlenwasserstoffe, bevorzugt sind dabei Hexan, Heptan, Cyclohexan, Toluol sowie Dixylole. Es ist möglich, diese Lösemittel einzeln oder im Gemisch einzusetzen.

Bevorzugt sind die Epoxidharz-Formmassen durch Glasgewebe oder Glasfasern verstärkt. Die Epoxidharz-Formmassen können auch mit Füllstoffen wie Quarzmehl oder Aluminiumoxidhydrat ausgerüstet werden.

Die Prüfung des Brandverhaltens wurde nach der Vorschrift von Underwriters Laboratories "Test for Flammability of Plastic Materials - UL 94" in der Fassung vom 02.05.1975 an Prüfkörpern von 127 mm Länge, 12,7 mm Breite und verschiedener Dicke durchgeführt. Der Sauerstoffindex wurde in einer Apparatur nach ASTM-D 2863-74 bestimmt.

Die erfindungsgemäßen Epoxidharz-Formmassen können zur Oberflächenbeschichtung verwendet werden. Sie können für den Verguß elektrischer Bauteile, für Laminate sowie für Klebstoffe verwendet werden.

Nachfolgend wird die Erfindung durch Beispiele erläutert:

### Beispiel 1 (mit 2-Carboxyethan-methan-phosphinsäure)

In einem 500-ml-Fünfhalskolben mit Rückflußkühler, Rührerwelle, Thermometer und Feststoffdosierung werden 200 g eines Bisphenol-A-bisglycidylethers mit einem Epoxidwert von 5,5 mol/kg vorgelegt. Bei einer Badtemperatur von 100 °C werden portionsweise 41 g (0,27 mol) 2-Carboxyethan-methan-phosphinsäure dazugegeben. Nach 30 min wird eine klare Lösung mit einem Epoxidwert von 3,1 mol/kg erhalten. Nach weiteren 4 h Rühren bei 100 °C wird ein bei Raumtemperatur festes Epoxidharz mit einem Epoxidwert von 2,4 mol/kg und einem Phosphorgehalt von 3,5 Gew.-% erhalten.

### Beispiel 2 (mit 2-Carboxyethan-methan-phosphinsäure)

In einem 500-ml-Fünfhalskolben mit Rückflußkühler, Rührerwelle, Thermometer und Feststoffdosierung werden 100 g eines Bisphenol-A-bisglycidylethers mit einem Epoxidwert von 5,5 mol/kg vorgelegt. Bei einer Badtemperatur von 100 °C werden portionsweise 30,8 g (0,2 mol) 2-Carboxyethan-methan-phosphinsäure dazugegeben. Nach weiteren 2,5 h Rühren bei 100 °C wird ein bei Raumtemperatur festes Epoxidharz mit einem Epoxidwert von 1,3 mol/kg und einem Phosphorgehalt von 4,7 Gew.-% erhalten.

### Beispiel 3 (mit 2-Carboxyethan-methan-phosphinsäure)

In einem 2-1-Fünfhalskolben mit Rückflußkühler, Rührerwelle, Thermometer und Feststoffdosierung werden 842 g eines Bisphenol-A-bisglycidylethers mit einem Epoxidwert von 5,5 mol/kg und 234,8 g 2-Carboxyethan-methan-phosphinsäure vorgelegt. Es wird 1 h bei 95 °C gerührt. Anschließend werden 335 ml Methylethylketon während 2 h bei 95 °C zudosiert. Nach weiteren 2 h Rühren wird eine 80%ige Lösung eines phosphormodifizierten Epoxidharzes erhalten. Der Epoxidwert beträgt 1,7 mol/kg, der Phosphorgehalt 3,4 Gew.-%. Nach 12 Tagen Lagerung bei Raumtemperatur beträgt der Epoxidwert 1,7 mol/kg.

### Beispiel 4 (mit 2-Carboxyethan-phenyl-phosphinsäure)

In einem 250-ml-Fünfhalskolben mit Rückflußkühler, Rührerwelle, Thermometer und Feststoffdosierung werden 103 g eines Bisphenol-A-bisglycidylethers mit einem Epoxidwert von 5,5 mol/kg vorgelegt. Bei einer Badtemperatur von 120 °C werden portionsweise 28 g (0,14 mol) 2-Carboxyethan-phenyl-phosphinsäure dazugegeben. Nach 30 min wird eine klare Lösung mit einem Epoxidwert von 2,7 mol/kg erhalten. Nach weiteren 30 min Rühren bei 120 °C wird ein bei Raumtemperatur festes Epoxidharz mit einem Epoxidwert von 2,5 mol/kg und einem Phosphorgehalt von 3,3 Gew.-% erhalten.

### Beispiel 5 (mit 2-Carboxyethan-phenyl-phosphinsäure)

In einem 250-ml-Fünfhalskolben mit Rückflußkühler, Rührerwelle, Thermometer und Feststoffdosierung werden 100 g eines Bisphenol-A-bisglycidylethers mit einem Epoxidwert von 5,5 mol/kg vorgelegt. Bei einer Badtemperatur von 120 °C werden portionsweise 41,1 g (0,2 mol) 2-Carboxyethan-phenyl-phosphinsäure dazugegeben. Nach 30 min wird eine klare Lösung erhalten. Nach weiteren 30 min Rühren bei 120 °C wird ein bei Raumtemperatur festes Epoxidharz mit einem Epoxidwert von 1,5 mol/kg und einem Phosphorgehalt von 4,5 Gew.-% erhalten.

## Patentansprüche

1. Verfahren zur Herstellung von löslichen und/oder schmelzbaren, phosphormodifizierten Epoxidharzen, **dadurch gekennzeichnet, dass** man eine Polyepoxidverbindung mit mindestens 2 Epoxidgruppen pro Molekül mit carboxylhaltigen Phosphinsäuren der Formel (I) 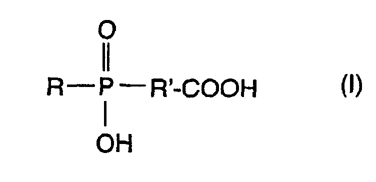 in der R geradlinige oder verzweigte Alkyl-, Cycloalkyl-, Aryl- oder Alkylarylgruppen mit 1 bis 18 C-Atomen oder Wasserstoff, R' geradlinige oder verzweigte Alkylen-, Cycloalkylen-, Arylen- oder Alkylarylengruppen mit 1 bis 18 C-Atomen bedeuten, umsetzt.

2. Verfahren nach Anspruch 1, **dadurch gekennzeichnet, daß** R eine geradlinige oder verzweigte Alkyl-, Cycloalkyl- oder Arylgruppe mit 1 bis 6 C-Atomen bedeutet.

3. Verfahren nach Anspruch 1 oder 2, **dadurch gekennzeichnet, daß** R' eine geradlinige oder verzweigte Alkylen-, Cycloalkylen- oder Arylengruppe mit 1 bis 6 C-Atomen bedeutet.

4. Verfahren nach mindestens einem der Ansprüche 1 bis 3, **dadurch gekennzeichnet, daß** man als Phosphinsäure 2-Carboxyethan-methan-phosphinsäure einsetzt.

5. Verfahren nach mindestens einem der Ansprüche 1 bis 3, **dadurch gekennzeichnet, daß** man als Phosphinsäure 2-Carboxyethan-phenyl-phosphinsäure einsetzt.

6. Verfahren nach mindestens einem der Ansprüche 1 bis 3, **dadurch gekennzeichnet, daß** man als Phosphinsäure 2-Carboxymethyl-methan-phosphinsäure einsetzt.

7. Verfahren nach einem oder mehreren der Ansprüche 1 bis 6, **dadurch gekennzeichnet, daß** R' eine Alkylengruppe mit 1 oder 2 C-Atomen bedeutet.

8. Verfahren nach einem oder mehreren der Ansprüche 1 bis 7, **dadurch gekennzeichnet, daß** die Umsetzung in einem Lösungsmittel erfolgt.

9. Verfahren nach Anspruch 8, **dadurch gekennzeichnet, daß** aprotische, polare Lösungsmittel, wie N-methylpyrrolidon, Dimethylformamid, Tetrahydrofuran, Dioxan, Dialkylether, Glykolether, Ketone und/oder Ester eingesetzt werden.

10. Verfahren nach Anspruch 8, **dadurch gekennzeichnet, daß** als Lösungsmittel halogenierte Kohlenwasserstoffe, aliphatische, cycloaliphatische und/oder aromatische Kohlenwasserstoffe, einzeln oder als Gemische, eingesetzt werden.

11. Verfahren nach einem oder mehreren der Ansprüche 1 bis 10, **dadurch gekennzeichnet, daß** die Umsetzung bei Temperaturen von 20 bis 150 °C erfolgt.

12. Verfahren nach einem oder mehreren der Ansprüche 1 bis 11, **dadurch gekennzeichnet, daß** das Äquivalentverhältnis zwischen Polyepoxidverbindung und carboxylgruppenhaltiger Phosphin- und/oder Phosphonsäure 1 : 0,1 bis 1 : 0,8 beträgt.

13. Verwendung des phosphormodifizierten Epoxidharzes erhalten nach einem der Ansprüche 1 bis 12 zur Herstellung von Formkörpern, Beschichtungen oder Laminaten.

14. Formkörper, Beschichtungen oder Laminate, hergestellt unter Verwendung des phosphormodifizierten Epoxidharzes erhalten nach einem oder mehreren der Ansprüche 1 bis 12.

## Claims

1. A process for preparing soluble and/or meltable, phosphorus-modified epoxy resins, which comprises reacting a polyepoxide compound having at least 2 epoxide groups per molecule with carboxyl-containing phosphinic acids of the formula (I) 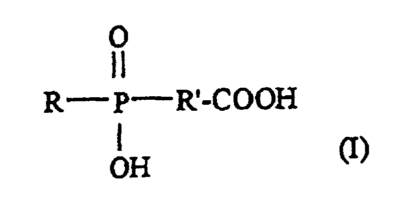 in which R is linear or branched alkyl, cycloalkyl, aryl or alkylaryl groups having 1 to 18 carbon atoms or is hydrogen and R' is linear or branched alkylene, cycloalkylene, arylene or alkylarylene groups having 1 to 18 carbon atoms.

2. The process as claimed in claim 1, wherein R is a linear or branched alkyl, cycloalkyl or aryl group having 1 to 6 carbon atoms.

3. The process as claimed in claim 1 or 2, wherein R' is a linear or branched alkylene, cycloalkylene or arylene group having 1 to 6 carbon atoms.

4. The process as claimed in at least one of claims 1 to 3, wherein the phosphinic acid employed is 2-carboxyethanemethanephosphinic acid.

5. The process as claimed in at least one of claims 1 to 3, wherein the phosphinic acid employed is 2-carboxyethanephenylphosphinic acid.

6. The process as claimed in at least one of claims 1 to 3, wherein the phosphinic acid employed is 2-carboxymethylmethanephosphinic acid.

7. The process as claimed in one or more of claims 1 to 6, wherein R' is an alkylene group having 1 or 2 carbon atoms.

8. The process as claimed in one or more of claims 1 to 7, wherein the reaction takes place in a solvent.

9. The process as claimed in claim 8, wherein aprotic polar solvents such as N-methylpyrrolidone, dimethylformamide, tetrahydrofuran, dioxane, dialkyl ethers, glycol ethers, ketones and/or esters are employed.

10. The process as claimed in claim 8, wherein solvents employed are halogenated hydrocarbons, aliphatic, cycloaliphatic and/or aromatic hydrocarbons, individually or as mixtures.

11. The process as claimed in one or more of claims 1 to 10, wherein the reaction takes place at temperatures from 20 to 150°C.

12. The process as claimed in one or more of claims 1 to 11, wherein the ratio of equivalents between polyepoxide compound and carboxyl-containing phosphinic and/or phosphonic acid is from 1:0.1 to 1:0.8.

13. The use of a phosphorus-modified epoxy resin obtained as claimed in one of claims 1 to 12 for producing moldings, coatings or laminates.

14. A molding, coating or laminate produced using a phosphorus-modified epoxy resin obtained as claimed in one or more of claims 1 to 12.

## Revendications

1. Procédé pour la préparation de résines époxydes modifiées par du phosphore, solubles et/ou fusibles, **caractérisé en ce qu'**on fait réagir un composé polyépoxyde présentant au moins 2 groupes époxydes par molécule sur des acides phosphiniques présentant des groupes carboxyle de formule (I) 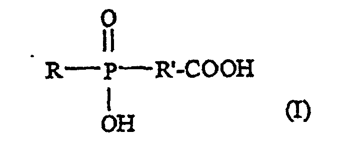 où R représente un groupe alkyle à chaîne droite ou ramifiée, cycloalkyle, aryle ou alkylaryle présentant 1 à 18 atomes de carbone ou un atome d'hydrogène, R' représente un groupe alkylène à chaîne droite ou ramifiée, cycloalkylène, arylène ou alkylarylène présentant 1 à 18 atomes de carbone.

2. Procédé selon la revendication 1, **caractérisé en ce que** R représente un groupe alkyle à chaîne droite ou ramifiée, cycloalkyle ou aryle présentant 1 à 6 atomes de carbone.

3. Procédé selon la revendication 1 ou 2, **caractérisé en ce que** R' représente un groupe alkylène à chaîne droite ou ramifiée, cycloalkylène ou arylène présentant 1 à 6 atomes de carbone.

4. Procédé selon au moins une des revendications 1 à 3, **caractérisé en ce qu'**on utilise comme acide phosphinique l'acide 2-carboxyéthane-méthane-phosphinique.

5. Procédé selon au moins une des revendications 1 à 3, **caractérisé en ce qu'**on utilise comme acide phosphinique l'acide 2-carboxyéthane-phényl-phosphinique.

6. Procédé selon au moins une des revendications 1 à 3, **caractérisé en ce qu'**on utilise comme acide phosphinique l'acide 2-carboxyméthyl-méthane-phosphinique.

7. Procédé selon une ou plusieurs des revendications 1 à 6, **caractérisé en ce que** R' représente un groupe alkylène présentant 1 ou 2 atomes de carbone.

8. Procédé selon une ou plusieurs des revendications 1 à 7, **caractérisé en ce qu'**on met en oeuvre la réaction dans un solvant.

9. Procédé selon la revendication 8, **caractérisé en ce qu'**on utilise des solvants aprotiques, polaires, tels que la N-méthylpyrrolidone, le diméthylformamide, le tétrahydrofuranne, le dioxanne, des éthers dialkyliques, des éthers de glycols, des cétones et/ou esters.

10. Procédé selon la revendication 8, **caractérisé en ce qu'**on utilise en tant que solvants des hydrocarbures halogénés, des hydrocarbures aliphatiques, cycloaliphatiques et/ou aromatiques, seuls ou en mélange.

11. Procédé selon une ou plusieurs des revendications 1 à 10, **caractérisé en ce qu'**on met en oeuvre la réaction à une température de 20 à 150°C.

12. Procédé selon une ou plusieurs des revendications 1 à 11, **caractérisé en ce que** le rapport d'équivalents du composé polyépoxyde et de l'acide phosphinique et/ou phosphonique présentant des groupes carboxyle est de 1:0,1 à 1:0,8.

13. Utilisation de la résine époxyde modifiée par du phosphore obtenue selon l'une des revendications 1 à 12 pour la fabrication de corps moulés, de revêtements ou de stratifiés.

14. Corps moulés, revêtements ou stratifiés, préparés à l'aide de la résine époxyde modifiée par du phosphore obtenue selon une ou plusieurs des revendications 1 à 12.
